# EUROPEAN PATENT SPECIFICATION

(11) **EP 2 461 371 B1**
(45) Date of publication and mention of the grant of the patent: **25.03.2015**
(21) Application number: 11009037.0
(22) Date of filing: 14.11.2011
(51) Int. Cl.: H01L 31/048, H01L 31/0203, H01L 31/0232

(54) **Solar cell module**
Solarzellenmodul
Module de cellule solaire

(30) Priority: 15.11.2010 KR 20100113369
(43) Date of publication of application: 06.06.2012
(73) Proprietor: LG ELECTRONICS INC., Yeongdeungpo-gu Seoul 150-721 (KR)
(72) Inventor: Hong, Seeun, Kyungsangnam-do 641-110 (KR)
(74) Representative: Frenkel, Matthias Alexander

(56) References cited:
- EP-A2- 2 104 148
- DE-A1-102008 013 522
- US-A1- 2009 320 921
- US-A1- 2010 212 740

## Description

### BACKGROUND

### Field of the Disclosure

The present disclosure relates to a solar cell, and more particularly, to a solar cell effectively protected from an external impact and moisture.

### Description of the Related Art

Recently, as it is expected that conventional energy resource such as petroleum and coal will be exhausted, interest in alternative energy replacing the conventional energy resources is gradually increasing. Among them, a solar cell is spotlighted as a new generation cell using a semiconductor device for directly converting solar energy into electric energy.

In other words, a solar cell is a device converting the solar energy into the electric energy by using a photovoltaic effect. Solar cells can be classified into a crystal silicon solar cell, a thin-film solar cell, a dye-sensitized solar cell, and an organic solar cell. The crystal silicon solar cell is generally used; however, the cost of materials thereof is high and the efficiency is relatively low. Also, the process for manufacturing the crystal silicon solar cell is complicated, and the cost of the crystal silicon solar cell varies because the crystal silicon is used in various industries or products. Accordingly, in order to overcome the above problems, there is rising interest in a thin film solar cell in which a thin silicon layer is deposited on a surface of relatively inexpensive glass or plastic.

US 2009/0320921 A1 describes a photovoltaic glazing assembly including first and second substrates wherein at least one is formed of a light transmitting material. In some embodiments, a seal system encloses a gas space between the substrates. The seal system preferably has contiguous inner and outer seals each extending between second surfaces of the two substrates, the second surfaces facing each other, so as to seal the first and second substrates to one another along their peripheries. The photovoltaic glazing assembly can optionally include one or more openings formed in one or both substrates, e.g., in the second substrate the openings may be used to equalize pressure within the assembly during manufacture or processing and/or to fill the gas space with another gas. Further, a preformed seal opening may be provided in addition to or instead of the openings.

DE 10 2008 013 522 A1 describes a solar module comprising a flat substrate with a circumferential substrate edge region, a flat polymer sealing element which at least partially covers the substrate, a plurality of solar cells which are arranged in a module interior between the substrate and the polymer sealing element, and a sealing device which is arranged in the substrate edge region and has at least one sealing element. The edge region of a first embodiment of the solar module whose horizontal dimension approximately corresponds to the substrate edge region is encompassed in u-shape by a pressing means. In the first embodiment of the solar module, the pressing means is formed as a u-shaped frame arrangement and an adhesive connecting the frame device with the edge region of the solar module. Therein, the adhesive fills the intermediate space between the frame device and the edge region of the solar module.

### SUMMARY

The present disclosure is directed to a solar cell effectively protected from external impact and moisture.

In addition, the present disclosure is directed to a solar cell protected by a small amount of a protector.

A solar cell module according to an embodiment of the present invention is the one given in claim 1.

### BRIEF DESCRIPTION OF THE DRAWINGS

FIG. 1 is a rear view of a solar cell module according to an embodiment of the present invention.

FIG. 2 is a cross-sectional view of the solar cell module shown in FIG. 1.

FIG. 3 is an expanded view of portion A of the solar cell module shown in FIG. 2.

FIG. 4 is an expanded view of portion B of the solar cell module shown in FIG. 2.

FIG. 5 is a rear view of a solar cell module according to another embodiment of the present invention.

FIG. 6 is a rear view of a solar cell module according to yet another embodiment of the present invention.

### DETAILED DESCRIPTION OF THE PREFERRED EMBODIMENTS

In the following description, it will be understood that when a layer or film is referred to as being "on" another layer or substrate, it can be directly on the other layer or substrate, or intervening layers may also be present. Further, it will be understood that when a layer is referred to as being "under" another layer, it can be directly under the other layer, and one or more intervening layers may also be present. In the figures, the dimensions of layers and regions are exaggerated or schematically illustrated, or some layers are omitted for clarity of illustration. In addition, the dimension of each part as drawn may not reflect an actual size.

Hereinafter, embodiments of the present invention will be described with reference to the accompanying drawings.

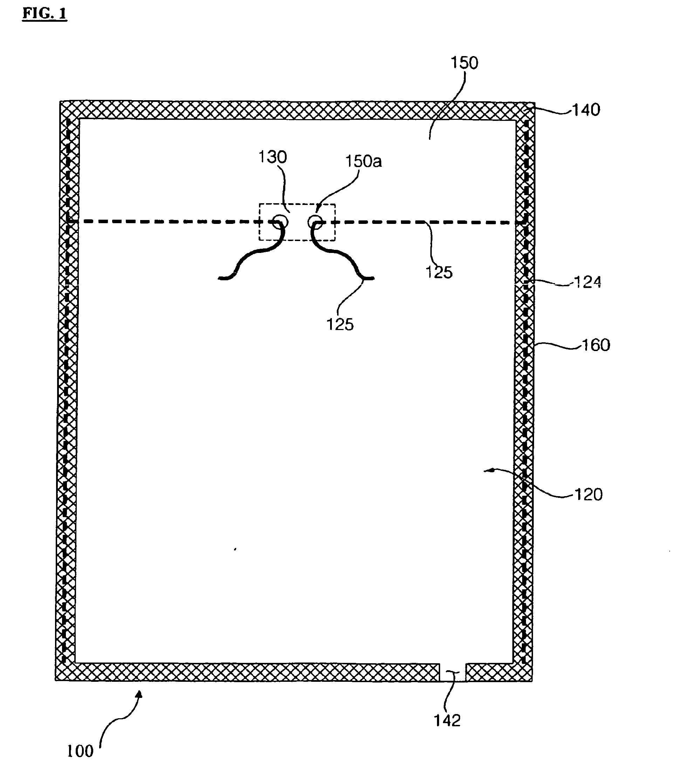

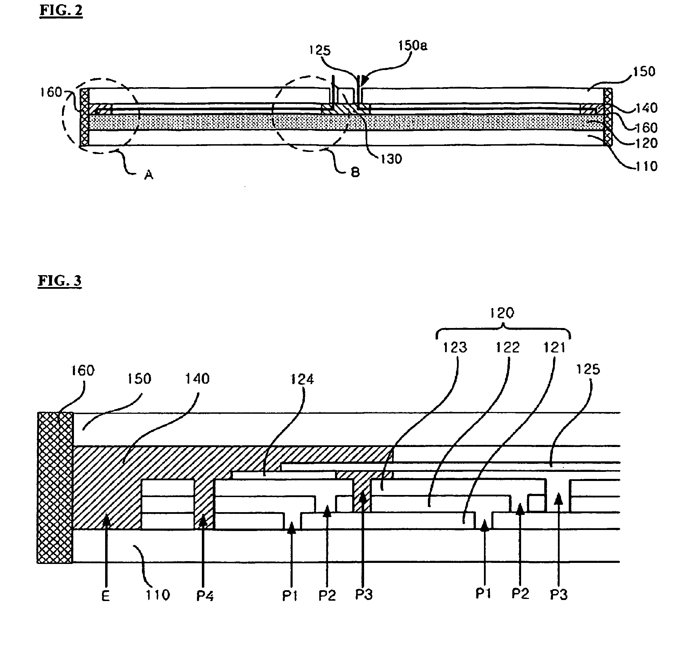

FIG. 1 is a rear view of a solar cell module 100 according to an embodiment of the present invention, and FIG. 2 is a cross-sectional view of the solar cell module 100 shown in FIG. 1.

A solar cell module according to an embodiment of the present invention includes a front substrate 110, a rear substrate 150 facing the front substrate 110, a plurality of solar cells 120 positioned on the front substrate between the front substrate 110 and the rear substrate 150, and a protector 140 formed between the front substrate 110 and the rear substrate 150.

The front substrate 110 may be formed of glass so that the sun light can penetrate. The front substrate 110 may be tempered glass in order to protect the solar cells 120 from an external impact. Specifically, the front substrate 110 may be low-iron tempered glass in order to prevent the reflection of sun light and improve the transmissivity of the sun light.

The front substrate 110 includes a light-incident surface that the sun light is incident and an inner surface opposite to the light-incident surface. The front substrate 110 may have a substantially rectangular shape.

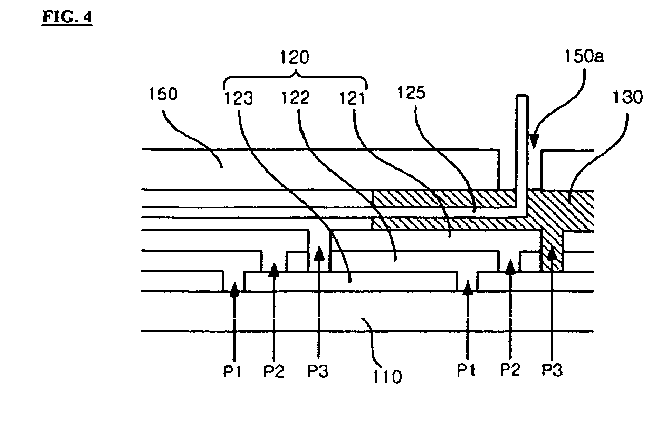

The solar cells 120 is positioned between the front substrate 110 and the rear substrate 150. The solar cells 120 is formed on the inner surface of the front substrate 110 and generate the electric energy from the sun light penetrating the front substrate 110. The detailed structure of the solar cells 120 will be described with reference to FIGs. 3 and 4.

The solar cells 120 may include a ribbon 124 for collecting current generated from the solar cells 120. The solar cells 120 may have a substantially rectangular shape, corresponding to the front substrate 110. The ribbon 124 may include a plurality of ribbons 124 formed at a periphery portion along edges of the solar cells 120. As shown, the ribbon 124 may be formed on the outermost portion of the two long edges of the solar cells 120.

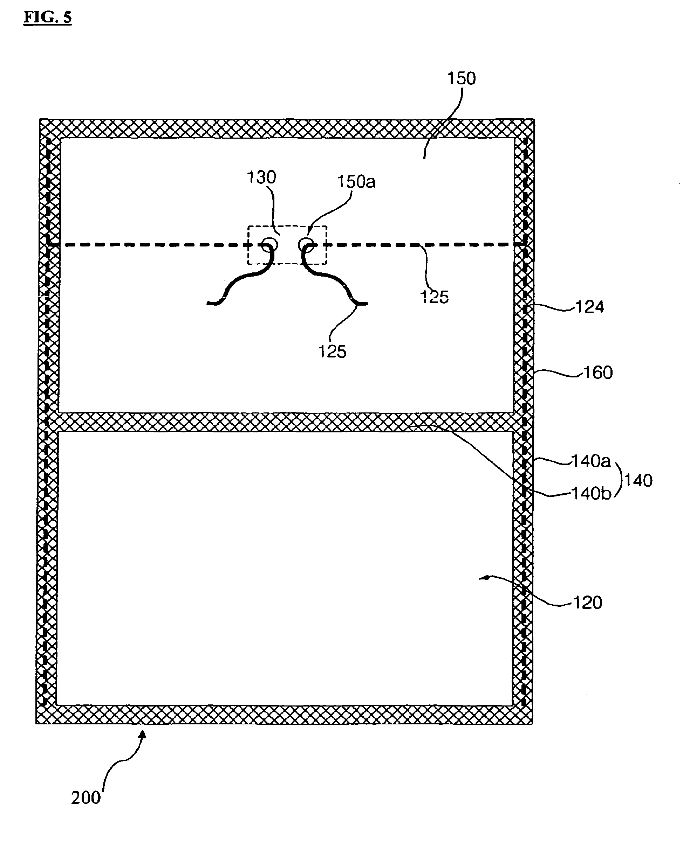

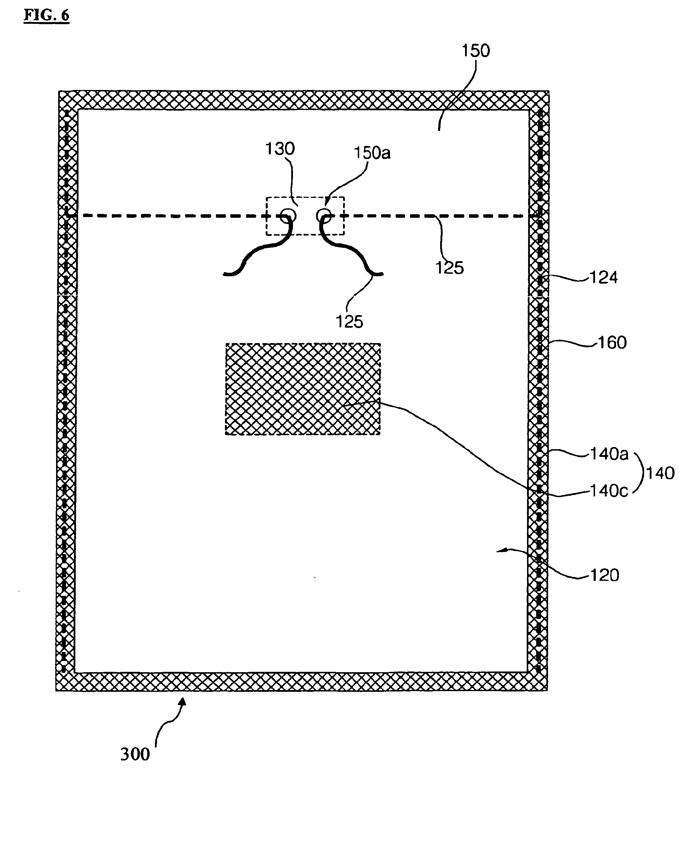

The protector 140 may be formed between the front substrate 110 and the rear substrate 150. More specifically, the protector 140 may be formed between the solar cells 120 and the rear substrate 150 at the portion where the solar cells 120 are formed. Further, the protector 140 may also be formed between the inner surface of the front substrate 110 and a reflection surface of the rear substrate 150 at the portion where the solar cells 120 are not formed. In the present embodiment, the protector 140 includes only a periphery portion formed between the periphery of the solar cells 120 and the periphery of the rear substrate 150 or between the periphery of the front substrate 110 and the periphery of the rear substrate 150. However, the present invention is not limited thereto. Thus, the protector 140 may include the other portion besides the periphery portion, and it will be described in more detail with reference to FIGs. 5 and 6.

The protector 140 may be formed on the ribbon 124. The protector 140 may have a width of about 10∼30 mm, and a thickness of about 0.5mm.

In the present embodiment, the protector 140 includes an exhaust hole 142 for evacuating the space between the front substrate 110 and the rear substrate 150. The exhaust hole 142 may be formed by not completely enclosing the protector 140 on a part of the front substrate 110 and the solar cells 120. Air between the rear substrate 150 and the solar cells 120 may be evacuated through the exhaust hole 142.

The protector 140 may include at least one of a polybutylene-based material (such as, butyl rubber) and a polyvinyl-based material (such as, polyvinyl butyral (PVB) ) in order to protect the solar cell module 100 from an external impact, moisture, oxygen, and other foreign substances. For example, the protector 140 may be a tape type that is adhered to the periphery of the front substrate 110 and the solar cells 120.

The protector 140 may also have an adhesive property to adhere the periphery of the front substrate 110 and the solar cells 120 and to the periphery of the rear substrate 150.

The rear substrate 150 faces the front substrate 110 interposing the solar cells 120 therebetween. The rear substrate 150 may be formed on the protector 140. In another embodiment, the periphery of the rear substrate 150 may be formed on the protector 140, and the rear substrate 150 and the solar cells 120 are spaced from each other interposing a space therebetween.

The rear substrate 150 may waterproof, insulate, or filter ultraviolet light. The rear substrate 150 may be a TPT (Tedlar / PET / Tedlar) type; but is not limited thereto. In addition, the rear substrate 150 may include a high reflectivity property in order to reuse the sun light transmitted through the front substrate 110, or include a transparent property that allows the sun light to be incident. In the present embodiment, the rear substrate 150 may be tempered glass.

The rear substrate 150 may include an internal reflective surface to reflect the sun light opposite an external surface. The rear substrate 150 may have a substantially rectangular shape, corresponding to the front substrate 110.

The solar cell module 100 according to an embodiment may further include a lead line 125 connected to the ribbon 124 to transfer the current collected by the ribbon 124 to the outside. The lead line 125 may be connected to a junction box (not shown) positioned on the external surface of the rear substrate 150. The junction box may include condensers for charging and discharging the electric energy and diodes for preventing countercurrent. The lead line 125 may include a plurality of lead lines 125 corresponding to a plurality of ribbons 124.

The lead line 125 may be transitioned to the outside of the solar cell module 100 by penetrating a lead-line hole 150a formed at the rear substrate.125. The lead line 125 may pass through the empty space between the reflection surface of the rear substrate 150 and the solar cells 120 and penetrate the lead-line hole 150a. The lead-line hole 150a may correspond to the location of the junction box, and may include a plurality of lead-line holes corresponding to a plurality of lead lines 125.

The lead line 125 may include a metal portion having a thin band shape and having high conductivity (such as, copper or silver) and an insulation film covering the metal portion for insulating the metal portion from the plurality of the solar cells 120. Another insulation film may be positioned between the lead line 125 and the solar cells 120.

The solar cell module 100 according to an embodiment may include a blocking medium 130 formed between a portion of the lead-line hole 150a of the rear substrate 150 and the solar cells 120. The blocking medium 130 may include a solid sealant in order to block moisture, oxygen, and other foreign substances from permeating through the lead-line hole 150a. The blocking medium 130 may include at least one of a polybutylene-based material and a polyvinyl-based material. The blocking medium 130 may be separated from the protector 140 not to be adjacent to the protector 140.

As shown in FIG. 2, the solar cell module 100 according to the present embodiment further includes a barrier 160 formed on side surfaces of the front substrate 110, the protector 140, and the rear substrate 150. The barrier 160 blocks moisture, oxygen, and other foreign substances by surrounding the circumference of the solar cell module. The barrier 160 may include a silicon-based material.

FIG. 3 is an expanded view of portion A of the solar cell module 100 shown in FIG. 2. FIG. 4 is an expanded view of portion B of the solar cell module 100 shown in FIG. 2.

The solar cell 120 may include a transparent electrode layer 121 formed on the front substrate 110, a photoelectric conversion layer 122 formed on the transparent electrode layer 121 to convert the solar energy into electric energy, and a rear electrode layer 123 formed on the photoelectric conversion layer 122. Here, the transparent electrode layer 121 and the rear electrode layer 123 may be formed by deposition.

The transparent electrode layer 121 may act as a path for allowing current generated from the photoelectric conversion layer 122 to flow. The transparent electrode layer 121 may include ZnO doped with at least one of Al, Ga, F, Ge, Mg, B, In, Sn, and Li. In an embodiment, the transparent electrode layer 121 may include ZnO:Al or SnO:Al, or have a stacked structure of ZnO:Al and SnO:Al.

The dopant may improve the charge carrying property of ZnO. In addition, the doped ZnO may be more easily etched compared to Indium Tin Oxide (ITO), and is non toxic, and is grown at a low temperature.

The ZnO may be doped with metal elements by a chemical doping method, an electrochemical doping method, or an ion implantation; however, the present invention is not limited thereto.

The surface of the transparent electrode layer 121 may be textured to have an uneven surface, thereby allow the photoelectric conversion layer 122 to absorb more light.

In the photoelectric conversion layer 122, a P-N junction may be formed, and thus, electric energy is generated by a photoelectric effect when the sun light is incident. The photoelectric conversion layer 122 may include amorphous silicon (a-Si), microcrystalline silicon (uc-Si), a compound semiconductor, or a tandem structure.

The rear electrode layer 123 may be deposited on the photoelectric conversion layer 122. The rear electrode layer 123 may act as a path for allowing current generated from the photoelectric conversion layer 122 to flow. The rear electrode layer 123 may include a transparent material or an opaque material (such as Ag or Al). The rear electrode layer 123 may be formed similar to the transparent electrode layer 121. The rear electrode layer 123 may include ZnO:Al or SnO:Al, or have a stacked structure of ZnO:Al and SnO:Al.

A first groove P1 may be formed by a first scribing after the transparent electrode layer 121 is formed on the inner surface of the front substrate 110. A second groove P2 may be formed by a second scribing after the photoelectric conversion layer 122 is formed on the transparent electrode layer 121. The second groove P2 may be filled with the material of the rear electrode layer 123 when the rear electrode layer 123 is formed on the photoelectric conversion layer 122. That is, the rear electrode layer 123 and the transparent electrode layer 121 may be electrically connected through the second groove P2. And then, a third groove P3 may be formed by a third scribing of the photoelectric conversion layer 122. The rear electrode layer 123 and the plurality of the solar cells 120 can be divided by the third groove P3. Accordingly, the plurality of the solar cells 120 may be electrically connected in series. In addition, after forming the third groove P3, a fourth groove P4 may be formed at the transparent electrode layer 121, the photoelectric conversion layer 122, and the rear electrode layer 123. An edge deletion E may be performed to insulate the solar cells 120.

The ribbon 124 may be on an outer most cell among the solar cells 120 formed at the periphery of the solar cell module 100. The outer most cells among the solar cells 120 may be cells formed between the third groove P3 and the fourth groove P4. The ribbon 124 may be positioned on the rear electrode layer 123 of the outer most solar cells 120. However, the present invention is not limited thereto. Thus, the other embodiments, the ribbon 124 may be formed on the transparent electrode layer 121 of the outer most cells among the plurality of the solar cells 120.

The ribbon 124 may be adhered to the outer most cells among the solar cells 120 by a conductive paste having Ag, a conductive film having a resin with a plurality of conductive particles in the resin, or spot soldering. In another embodiment, the ribbon 124 may be formed by direct-printing on the outmost cell among the solar cells 120. Between the ribbon 124 and the outmost cell among the solar cells 120, a bus bar of a metal having a high conductivity (such as, Ag) may be positioned.

Referring to FIG. 3, the protector 140 may be positioned on a portion of the fourth groove P4 and the edge deletion E. Further, the protector 140 may be formed at the periphery of the inner surface of the front substrate 110 and the periphery of the rear electrode layer 123. In addition, the protector 140 may also be formed on a portion of the third groove P3. In this case, the protector 140 may be formed on the transparent electrode layer 121 and the ribbon 124 of the outer most cells among the solar cells 120 that is exposed by the third groove P3.

Referring to FIG. 4, the blocking medium 130 may be formed up to the portion of the third groove P3. In this case, the blocking medium 130 may be formed on the transparent electrode layer 121 and the rear electrode layer 123. The blocking medium 130 may be in close contact with the rear substrate 150, and thus, blocks moisture, oxygen, and other foreign substances which may permeate through the lead-line hole 150a.

Hereinafter, a method for manufacturing the solar cell module according to an embodiment will be described.

The first groove P1 may be formed by the first scribing after the transparent electrode layer 121 is formed on the inner surface of the front substrate 110. The second groove P2 may be formed by a second scribing after the photoelectric conversion layer 122 is formed on the transparent electrode layer 121. And then, the third groove P3 may be formed by a third scribing of the photoelectric conversion layer 122. Accordingly, the plurality of the solar cells 120 may be electrically connected in series. After forming the third groove P3, the solar cells 120 may be insulated by a fourth scribing for forming the fourth groove P4 and the edge deletion E. The ribbon 124 may be positioned on the outer most cells of the solar cells 120, and the lead line 125 may be connected to the ribbon 124.

The protector 140 may be formed on the periphery of the front substrate 110 and the periphery of the solar cells 120. The blocking medium 130 may be positioned at the portion of the lead-line hole 150a at the rear substrate 150 of the solar cells 120. The rear substrate 150 may be stacked on the protector 140, the periphery of the front substrate 110 and the solar cells 120. The rear substrate 150 may be adhered at the periphery.

The periphery portion of the protector 140 includes the exhaust hole 142 for evacuating between the front substrate 110 and the rear substrate 150. For example, the exhaust hole 142 may be formed by not fully enclosing the protector 140 on the part of the front substrate 110 and the solar cells 120. The air between the rear substrate 150 and the solar cells 120 may be evacuated through the exhaust hole 142 to form a vacuum. The barrier 160 is formed on the side surfaces of the front substrate 110, the protector 140, and the rear substrate 150, thereby sealing the exhaust hole 142.

FIG. 5 is a rear view of a solar cell module 200 according to another embodiment of the present invention.

The protector 140 according to another embodiment may be formed on an inside of the solar cells 120 as well as the periphery of the front substrate 110 and the solar cells 120. Thus, the protector 140 can provide further mechanical support to the module 200 when the solar cell module 200 has a large area. That is, the protector 140 may be located at the periphery portion 140a and at a bridge portion 140b connecting two portions of the periphery portion 140a across from each other. The bridge portion 140b may connect two portions along the long edges of the front substrate 110. The bridge portion 140b may be positioned at a center of two portions along the short edges of the front substrate 110 or may include a plurality bridge portions with the same intervals. The bridge portion 140b may be separated from the blocking medium 130.

FIG. 6 is a rear view of a solar cell module 300 according to yet another embodiment of the present invention.

The protector 140 according to another embodiment may include the periphery portion 140a formed at the periphery and an island portion 140c separated from the periphery portion 140a. The island portion 140c may be positioned at a center portion of the solar cell module 300 or anywhere else. The island portion 140c may be separated from the blocking medium 130.

According to the solar cell modules of the embodiments, there is at least one effect as follows:

First, the protector 140 for protecting the solar cell module from external impact, moisture, oxygen, and foreign substances may be positioned at the periphery of the solar cell module. Thus, cost efficiency can be improved.

Secondly, the lead line 125 for transferring the current to the outside may be exposed while penetrating the rear substrate 150. Thus, current transfer efficiency can be enhanced.

Thirdly, the permeation of moisture, oxygen, and foreign substances can be blocked by the blocking medium 130 positioned at a portion where the lead line 125 penetrates the rear substrate 150.

Fourthly, the rear substrate 150 may be tempered glass, and damage of the solar cell module due to a weaker rear substrate can be prevented.

Fifthly, the barrier 160 may be formed to surround the circumference of the solar cell module, thereby blocking moisture, oxygen, and other foreign substances.

Certain embodiments of the present invention have been described. However, the present invention is not limited to the specific embodiments described above; various modifications of the embodiments are possible by those skilled in the art to which the present invention belongs without leaving the scope of the present invention defined by the appended claims.

## Claims

1. A solar cell module comprising:
a front substrate (110);
a rear substrate (150) facing the front substrate (110);
a plurality of solar cells (120) between the front substrate (110) and the rear substrate (150);
a protector (140) comprising a periphery portion formed between a periphery of the front substrate (110) and the plurality of solar cells (120) and 4 periphery of the rear substrate (150), wherein the protector (140) comprises an exhaust hole (142) between the front substrate (110) and the rear substrate (150) for evacuating a space between the front substrate (110) and the rear substrate (150); to form a vacuum and
a barrier (160) formed on side surfaces of the front substrate (110), the protector (140), and the rear substrate (150), wherein the barrier (160) blocks the exhaust hole (142) to maintain the vacuum.

2. The solar cell module according to claim 1, wherein the protector (140) is positioned between the periphery of the front substrate (110) and the periphery of the rear substrate (150) where the plurality of solar cells (120) are not formed.

3. The solar cell module according to claim 1, wherein the protector (140) includes at least one of a polybutylene-based material and a polyvinyl-based material.

4. The solar cell module according to claim 1, wherein the protector (140) has a width of about 10-30 mm.

5. The solar cell module according to claim 1, wherein the plurality of solar cells (120) further comprises:
a transparent electrode layer (121) on the front substrate (110);
a photoelectric conversion layer (122) formed on the transparent electrode layer (121) to convert solar energy into electric energy; and
a rear electrode layer (123) formed on the photoelectric conversion layer (122).

6. The solar cell module according to claim 5, wherein the protector (140) is formed on the rear electrode layer (123) or on the transparent electrode layer (121).

7. The solar cell module according to claim 5, wherein the transparent electrode layer (121) comprises a first groove,
the photoelectric conversion layer (122) comprises a second groove to electrically connect the rear electrode layer (123) and the transparent electrode layer (121),
the photoelectric conversion layer (122) and the rear electrode layer (123) comprise a third groove, and
the protector (140) is formed on the rear electrode layer (123), wherein the transparent electrode layer (121) is exposed by the third groove.

8. The solar cell module according to claim 1, further comprising:
a ribbon (124) collecting current generated from the plurality of solar cells (120),
wherein the protector (140) is positioned on the ribbon (124).

9. The solar cell module according to claim 8, further comprising:
a lead line connected to the ribbon (124) and transferring the current to the outside,
wherein the lead line is exposed to the outside by penetrating through a lead-line hole formed at the rear substrate (150).

10. The solar cell module according to claim 9, further comprising:
a blocking medium positioned between a portion of the lead-line hole of the rear substrate (150) and the plurality of solar cells (120).

11. The solar cell module according to claim 10, wherein the blocking medium is spaced from the protector (140).

12. The solar cell module according to claim 1, wherein the protector (140) further comprises a bridge portion connected to the periphery portion and formed at an inside of the solar cell module or an island portion separated from the periphery portion.

13. The solar cell module according to claim 1, wherein the rear substrate (150) and the plurality of the solar cells (120) are spaced from each other interposing a space therebetween.

## Patentansprüche

1. Solarzellenmodul, umfassend:
ein vorderes Substrat (110);
ein dem vorderen Substrat (110) gegenüberliegendes hinteres Substrat (150);
mehrere Solarzellen (120) zwischen dem vorderen Substrat (110) und dem hinteren Substrat (150);
eine Schutzvorrichtung (140), umfassend einen äußeren Abschnitt, der zwischen einem äußeren Bereich des vorderen Substrats (110) und der Solarzellen (120) und einem äußeren Bereich des hinteren Substrats (150) ausgebildet ist, wobei die Schutzvorrichtung (140) ein zwischen dem vorderen Substrat (110) und dem hinteren Substrat (150) angeordnetes Entlüftungsloch (142) zum Evakuieren eines Bereichs zwischen dem vorderen Substrat (110) und dem hinteren Substrat (150) umfasst; und
eine Begrenzungsvorrichtung (160), die an Seitenflächen des vorderen Substrats (110), der Schutzvorrichtung (140) und des hinteren Substrats (150) ausgebildet ist, wobei die Begrenzungsvorrichtung (160) das Entlüftungsloch (142) blockiert.

2. Solarzellenmodul nach Anspruch 1, wobei die Schutzvorrichtung (140) zwischen dem äußeren Bereich des vorderen Substrats (110) und dem äußeren Bereich des hinteren Substrats (150) angeordnet ist, wo die Solarzellen (120) nicht ausgebildet sind.

3. Solarzellenmodul nach Anspruch 1, wobei die Schutzvorrichtung (140) ein Material auf Polybutylen-Basis und/oder ein Material auf Polyvinyl-Basis enthält.

4. Solarzellenmodul nach Anspruch 1, wobei die Schutzvorrichtung (140) eine Breite von etwa 10 bis etwa 30 mm aufweist.

5. Solarzellenmodul nach Anspruch 1, wobei die Solarzellen (120) ferner umfassen:
eine transparente Elektrodenschicht (121) auf dem vorderen Substrat (110);
eine photoelektrische Umwandlungsschicht (122), die auf der transparenten Elektrodenschicht (121) ausgebildet ist, um Solarenergie in elektrische Energie umzuwandeln; und
eine hintere Elektrodenschicht (123), die auf der photoelektrischen Umwandlungsschicht (122) ausgebildet ist.

6. Solarzellenmodul nach Anspruch 5, wobei die Schutzvorrichtung (140) auf der hinteren Elektrodenschicht (123) oder auf der transparenten Elektrodenschicht (121) ausgebildet ist.

7. Solarzellenmodul nach Anspruch 5, wobei die transparente Elektrodenschicht (121) eine erste Ausnehmung umfasst,
wobei die photoelektrische Umwandlungsschicht (122) eine zweite Ausnehmung umfasst, um die hintere Elektrodenschicht (123) und die transparente Elektrodenschicht (121) elektrisch zu verbinden,
wobei die photoelektrische Umwandlungsschicht (122) und die hintere Elektrodenschicht (123) eine dritte Ausnehmung umfassen, und
wobei die Schutzvorrichtung (140) auf der hinteren Elektrodenschicht (123) ausgebildet ist, wobei die transparente Elektrodenschicht (121) durch die dritte Ausnehmung freigelegt ist.

8. Solarzellenmodul nach Anspruch 1, ferner umfassend:
ein Band (124), das von den Solarzellen (120) erzeugten Strom sammelt, wobei die Schutzvorrichtung (140) auf dem Band (124) angeordnet ist.

9. Solarzellenmodul nach Anspruch 8, ferner umfassend:
eine Anschlussleitung, die mit dem Band (124) verbunden ist und den Strom nach außen überträgt, wobei die Anschlussleitung nach außen freigelegt ist, indem sie ein am hinteren Substrat (150) ausgebildetes Anschlussleitungsloch durchsetzt.

10. Solarzellenmodul nach Anspruch 9, ferner umfassend:
ein Blockiermedium, welches zwischen einem Abschnitt des Anschlussleitungslochs des hinteren Substrats (150) und den Solarzellen (120) angeordnet ist.

11. Solarzellenmodul nach Anspruch 10, wobei das Blockiermedium gegenüber der Schutzvorrichtung (140) beabstandet ist.

12. Solarzellenmodul nach Anspruch 1, wobei die Schutzvorrichtung (140) ferner einen mit dem äußeren Abschnitt verbundenen und auf einer Innenseite des Solarzellenmoduls ausgebildeten Brückenabschnitt oder einen von dem äußeren Abschnitt getrennten Inselabschnitt umfasst.

13. Solarzellenmodul nach Anspruch 1, wobei das hintere Substrat (150) und die Solarzellen (120) voneinander beabstandet sind und ein Abstand zwischen ihnen vorliegt.

## Revendications

1. Module de cellules solaires comprenant :
un substrat avant (110) ;
un substrat arrière (150) en regard du substrat avant (110) ;
une pluralité de cellules solaires (120) entre le substrat avant (110) et le substrat arrière (150) ;
un protecteur (140) comprenant une partie périphérique formée entre une périphérie du substrat avant (110) et de la pluralité de cellules solaires (120) et une périphérie du substrat arrière (150), dans lequel le protecteur (140) comprend un trou d'évacuation (142) entre le substrat avant (110) et le substrat arrière (150) destiné à évacuer un espace entre le substrat avant (110) et le substrat arrière (150) pour former un vide ; et
une barrière (160) formée sur les surfaces latérales du substrat avant (110), du protecteur (140), et du substrat arrière (150), dans lequel la barrière (160) bloque le trou d'évacuation (142) pour maintenir le vide.

2. Module de cellules solaires selon la revendication 1, dans lequel le protecteur (140) est positionné entre la périphérie du substrat avant (110) et la périphérie du substrat arrière (150) où les cellules solaires (120) en pluralité ne sont pas formées.

3. Module de cellules solaires selon la revendication 1, dans lequel le protecteur (140) comprend au moins l'un parmi un matériau à base de polybutylène et un matériau à base de polyvinyle.

4. Module de cellules solaires selon la revendication 1, dans lequel le protecteur (140) présente une largeur d'environ 10 à 30 mm.

5. Module de cellules solaires selon la revendication 1, dans lequel les cellules solaires (120) en pluralité comprennent en outre :
une couche d'électrode transparente (121) sur le substrat avant (110) ;
une couche de conversion photoélectrique (122) formée sur la couche d'électrode transparente (121) pour convertir à l'énergie solaire en énergie électrique ; et
une couche d'électrode arrière (123) formée sur la couche de conversion photoélectrique (122).

6. Module de cellules solaires selon la revendication 5, dans lequel le protecteur (140) est formé sur la couche d'électrode arrière (123) ou sur la couche d'électrode transparente (121).

7. Module de cellules solaires selon la revendication 5, dans lequel la couche d'électrode transparente (121) comprend une première rainure,
la couche de conversion photoélectrique (122) comprend une deuxième rainure pour connecter électriquement la couche d'électrode arrière (123) et la couche d'électrode transparente (121),
la couche de conversion photoélectrique (122) et la couche d'électrode arrière (123) comprennent une troisième rainure, et
le protecteur (140) est formé sur la couche d'électrode arrière (123), dans laquelle la couche d'électrode transparente (121) est exposée par la troisième rainure.

8. Module de cellules solaires selon la revendication 1, comprenant en outre :
un ruban (124) collectant le courant généré à partir de la pluralité de cellules solaires (120),
dans lequel le protecteur (140) est positionné sur le ruban (124).

9. Module de cellules solaires selon la revendication 8, comprenant en outre :
une ligne de conducteur connectée au ruban (124) et transférant le courant vers l'extérieur,
dans lequel la ligne de conducteur est exposée vers l'extérieur en pénétrant à travers un trou pour ligne de conducteur formé au niveau du substrat arrière (150).

10. Module de cellules solaires selon la revendication 9, comprenant en outre :
un milieu de blocage positionné entre une partie du trou pour ligne de conducteur du substrat arrière (150) et la pluralité de cellules solaires (120).

11. Module de cellules solaires selon la revendication 10, dans lequel le milieu de blocage est espacé du protecteur (140).

12. Module de cellules solaires selon la revendication 1, dans lequel le protecteur (140) comprend en outre une partie de pont connectée à la partie périphérique et formée au niveau de l'intérieur du module de cellules solaires ou une partie d'îlot séparée de la partie périphérique.

13. Module de cellules solaires selon la revendication 1, dans lequel le substrat arrière (150) et la pluralité de cellules solaires (120) sont espacés les uns des autres interposant un espace entre eux.
